# EUROPÄISCHE PATENTSCHRIFT

(11) **EP 0 952 765 B1**
(45) Veröffentlichungstag und Bekanntmachung des Hinweises auf die Patenterteilung: **25.06.2003**
(21) Anmeldenummer: 99107558.1
(22) Anmeldetag: 15.04.1999
(51) Int. Cl.: H05K 9/00

(54) **Kontaktstreifen zum elektrischen Kontaktieren und/oder zur Erzielung einer gegen hochfrequente elektromagnetische Wellen dichten Verbindung sowie zugehörige Abschirmanordnung**
Strip for making electrical contact and/or for EMI shielding, and corresponding shielded device
Bande de contact électrique et de blindage contre les ondes électromagnétiques ainsi que le dispositif blindé correspondant

(30) Priorität: 23.04.1998 DE 19818285
(43) Veröffentlichungstag der Anmeldung: 27.10.1999
(73) Patentinhaber: Kathrein-Werke KG, 83022 Rosenheim (DE)
(72) Erfinder: Staniszewski,Walter, 83229 Aschau (DE); Häntsch,Ralf, 83064 Raubling (DE)
(74) Vertreter: Flach, Dieter Dipl.-Ing

(56) Entgegenhaltungen:
- EP-A- 0 563 673
- EP-A- 0 757 514
- WO-A-86/07497

## Beschreibung

Die Erfindung betrifft Kontaktstreifen zum elektrischen Kontaktieren und zur Erzielung einer gegen hochfrequente elektromagnetische Wellen dichten Verbindung, insbesondere zwischen einem Gehäuse und einem Gehäusedeckel nach dem Oberbegriff des Anspruches 1 und 2 sowie eine zugehörige Abschirmanordnung.

Ein gattungsbildender Kontaktstreifen ist beispielsweise aus der DD 200 252 bekannt geworden. Er dient zum elektrisch dichten Verschließen von Schirmelementen, insbesondere von Abschirmungen und Cassetten. Dazu besteht er aus einem Metallblechstreifen, der quer zur Erstreckungsebene des Metallblechstreifens mit eingeprägten pyramidenförmigen vorstehenden Federelementen versehen ist, so dass jedes Federelement aus einer quer zur Ebene des Kontaktstreifens seitlich vorstehenden Zunge gebildet ist.

Ein insoweit vergleichbarer Kontaktstreifen ist auch aus der EP-B1-0 207 226 B1 bekannt geworden. Auch hier besteht der elektrische Kontaktstreifen aus einem Federblechstreifen mit einer Vielzahl von federnden Zungen, die durch einzelne quer zur Längsrichtung des Kontaktfederelementes von einer Seite her eingebrachte Nuten gebildet sind. Die einzelnen Federn und Zungen sind jeweils in einer Querschnittsebene quer zur Längsrichtung des Kontaktstreifens dach- bzw. bogenförmig gekantet, um eine Federwirkung quer zur Kontaktstreifenebene herzustellen.

Ein insoweit vergleichbares Kontakt-Federblech ist auch aus der EP-A-0 563 673 bekannt geworden. Dieses Dokument zeigt einen Kontaktstreifen zum elektrischen Kontaktieren und/oder zur Erzielung einer gegen elektromagnetische Wellen dichten Verbindung zwischen zwei Bauteilen, wobei die vielen Kontaktelemente ebenfalls aus einer Vielzahl von Kontaktfingern gebildet sind. Die Kontaktfinger sind aus einer aus einem Federblech freigeschnittenen Zunge gebildet, die nach beiden Seiten aufgebogene Abschnitte aufweist, also aus der eigentlichen Federblechebene seitlich vorsteht.

Neben derartigen Stanz- und Biegeteilen sind darüber hinaus als Dichtelemente auch Drahtformteile, Metallgeflechtschnüre oder -platten oder mit Metallpartikeln gefüllte Kunststoffelemente bekannt. Alle diese elektrischen Kontaktstreifen weisen aber herstellungsbedingte, funktionsbedingte und/oder kostenmäßige Nachteile auf.

Aufgabe der vorliegenden Erfindung ist es von daher, einen verbesserten Kontaktstreifen sowie eine zugehörige verbesserte Abschirmanordnung zu schaffen.

Die Aufgabe wird erfindungsgemäß bezüglich eines Kontaktstreifens entsprechend den im Anspruch 1 oder 2 und bezüglich einer Abschirmanordnung entsprechend der im Anspruch 22 angegebenen Merkmalen gelöst. Vorteilhafte Ausgestaltungen der Erfindung sind in den Unteransprüchen angegeben.

Der erfindungsgemäße Kontaktstreifen gemäß Anspruch 1 zeichnet sich vor allem dadurch aus, dass er allein nur durch Stanzen herstellbar ist, ohne dass - wie beim Stand der Technik - einzelne Federlamellen erst durch Erzeugung eines weiteren Prägeschrittes hergestellt werden müssen. Anders also als beim Stand der Technik werden die Zungen nicht zwangsläufig durch einen zusätzlich notwendigen Prägeschritt erzeugt.

Der erfindungsgemäße Kontaktstreifen zeichnet sich aber nicht nur durch seine höchst einfache und billige Herstellungsweise aus, sondern vor allem auch dadurch, dass er völlig problemlos als Meterware gefertigt werden kann, da alle Federelemente des Kontaktstreifens gleich ausgebildet sind.

Die erfindungsgemäßen Kontaktstreifen gemäß Anspruch 1 zeichnen sich dadurch aus, dass in Abweichung zum Stand der Technik keine Kontaktzungen gebildet sind, die um eine in Längsrichtung des Kontaktstreifen verlaufende Biegelinie seitlich gebogen sind (also aus der Ebene des Kontaktstreifenelementes seitlich herausgebogen sind, um dadurch eine elastische Federwirkung um die so gebildete Biegeachse zu erzeugen), sondern dadurch, dass die Federelemente in der Ebene des Kontaktstreifens liegen können. Mit anderen Worten sind die Kontakt- und Federelemente dadurch realisiert, dass sie fingerförmig gestaltet sind, wobei die Fingerspitze bzw. der Bereich in der Nähe der Fingerspitze als eigentlicher Kontaktierungsbereich ausgestaltet ist. Es wird also keine Kontaktierung in einem Bereich quer zur Kontaktstreifenebene wie beim Stand der Technik hergestellt.

In einer von der erfindungsgemäßen Lösung gemäß Anspruch 1 nur geringfügig abweichenden alternativen erfindungsgemäßen Lösung gemäß Anspruch 2 ist vorgesehen, dass die Kontaktfinger aus ihrer gemeinsamen Ebene zumindest teilweise seitlich ausgelenkt oder zu einer gemeinsamen Kontaktstreifen-Ebene parallel versetzt zueinander liegen können, wobei ansonsten die erfindungsgemäßen Vorteile vergleichbar der Lösung gemäß Anspruch 1 sind.

In einer besonders bevorzugten Ausführungsform ist vorgesehen, dass die Kontakt- und Federelemente, d.h. die Kontaktfinger, so gestaltet sind, dass sie sowohl in der mittleren Erstreckungsebene des Kontaktstreifens liegen, als auch zur Längsrichtung des Kontaktstreifens in einem spitzen Winkel geneigt ausgerichtet sind. Beim Einsatz und Zusammenbau können dabei dann die einzelnen Federelemente beispielsweise in der Ebene des Kontaktstreifens liegend verformt werden. Durch diese höchst einfache, aber zur Erzielung der gewünschten Vorteile sehr effektive Ausgestaltung des Kontaktstreifens lassen sich beispielsweise die folgenden Vorteile realisieren:
- Die Herstellung ist höchst billig und einfach, da der erfindungsgemäße Kontaktstreifen nur durch Stanzen (ohne weitere Formungsschritte) hergestellt werden kann, beispielsweise als Meterware;
- der erfindungsgemäße Kontaktstreifen erzwingt eine Vielzahl von unabhängigen Kontaktpunkten;
- der Platzbedarf für den erfindungsgemäßen Kontaktstreifen ist gegenüber dem Stand der Technik um ein Vielfaches geringer; während nämlich die Kontaktzungen beim Stand der Technik um eine parallel zur Längsrichtung des Kontaktstreifens verlaufende Biegekante gebogen werden müssen (wodurch sie seitlich aus der Kontaktstreifenebene hervorstehen), ist dies bei dem erfindungsgemäßen Kontaktstreifen nicht erforderlich; der erfindungsgemäße Kontaktstreifen benötigt beispielsweise nur einen schmalen Schlitz in einem Gehäuse oder in einem Deckel, um dort eingesetzt werden zu können;
- die vorstehend genannten Schlitze zum Aufnehmen des erfindungsgemäßen Kontaktstreifens lassen sich vor allem auch bei Gussteilen höchst einfach herstellen; zusätzliche Maßnahmen zum Halten des Kontaktstreifens, wie eingangs beim Stand der Technik beschrieben, sind nicht erforderlich;
- zudem können auch Sollbiege- und Sollbruchstellen in Abständen in Längsrichtung des erfindungsgemäßen Kontaktstreifens vorgesehen sein, so dass bei Bedarf ohne weitere Werkzeuge problemlos ein erfindungsgemäßer Kontaktstreifen in vorbestimmte und gewünschte Form und Länge gebracht werden kann;
- der erfindungsgemäße Kontaktstreifen weist einen guten elektrischen Kontakt mit den mit ihm zusammenwirkenden Bauteilen auf, da zwischen den Kontaktfingern und allen damit zusammenwirkenden Bauelementen beim Zusammenfügen der zu kontaktierenden Bauelemente (beispielsweise beim Aufsetzen eines Gehäusedeckels auf ein offenes Gehäuse) eine Gleitbewegung der freien Spitzenenden der Kontaktfinger bezogen auf die mit dem Kontaktstreifen zusammenwirkenden Bauteile stattfindet, wobei zudem auch Schichten aus Korrosionsprodukten oder anderen Fremdstoffen durchstoßen werden können;
- schließlich lassen sich auch noch hohe Flächenpressungen realisieren, da die Berührungsfläche zwischen dem erfindungsgemäßen Kontaktfinger und dem damit zusammenwirkenden Bauelement klein ist;
- der erfindungsgemäße Kontaktstreifen kann Oberflächenfehler bei mit ihm zusammenwirkenden Bauteilen gut ausgleichen;
- das erfindungsgemäße Kontaktstreifenelement verlängert sich nicht im eingebauten Zustand; und
- um den Abstand zwischen den Kontaktpunkten der einzelnen Federelemente zu verringern und damit das Schirmungsmaß bei hohen Frequenzen zu erhöhen, können problemlos auch mehrere Kontaktstreifen nebeneinander und versetzt liegend plaziert werden, was insbesondere bei Kontaktstreifen nach dem Stand der Technik grundsätzlich nicht möglich ist, da in Querrichtung zur Kontaktstreifenebene die vorstehenden Zungen vorgesehen sind und mit dem angrenzenden Bauteil zusammenwirken müssen;
- der erfindungsgemäße Kontaktstreifen ist wiederverwendbar, d.h. die mit dem Kontaktstreifen zusammenwirkenden Bauelemente können mehrmals montiert und demontiert werden.

Schließlich lässt sich der erfindungsgemäße Kontaktstreifen auch als Trennwand selbst nutzen, wenn die Trennwand an ihren Kontaktierungsstellen mit einer entsprechenden Kontaktstreifen-Struktur unter Ausbildung der erfindungsgemäßen Kontaktfinger versehen ist. Genauso lässt sich aber auch eine vielfache Masseverbindung beispielsweise zwischen einer Leiterplatine und einem Gehäuse unter Ausbildung der erfindungsgemäßen Federstruktur realisieren.

Eine erfindungsgemäße Abschirmanordnung ist unter Verwendung eines der erfindungsgemäßen Kontaktstreifens aufgebaut.

Die Erfindung wird nachfolgend unter Bezugnahme auf die beigefügten Zeichnungen für verschiedene Ausführungsbeispiele erläutert. Dabei zeigen im einzelnen:
- Figur 1a :: eine schematische Seitenansicht des erfindungsgemäßen Kontaktstreifens;
- Figur 1b und 1c :: zwei Abwandlungen gegenüber dem in den Figuren 1a und 2 wiedergegebenen Ausführungsbeispiel;
- Figur 2 :: eine Draufsicht auf den in Figur 1a ausschnittsweise gezeigten erfindungsgemäßen Kontaktstreifen;
- Figur 3 :: eine schematische Querschnittsdarstellung durch ein mit einem Deckel verschließbares Gehäuse unter Verwendung des erfindungsgemäßen Kontaktstreifens;
- Figur 4 :: eine entsprechende Darstellung zu Figur 3, bei welcher anstelle eines ein Gehäuse verschließenden Deckels eine Leiterplatine über den erfindungsgemäßen Kontaktstreifen mit einem Gehäuse kontaktiert ist;
- Figur 5 :: eine schematische auszugsweise Seitendarstellung auf ein Randelement, insbesondere Trennwandelement, welches an seinen Längsseiten mit der erfindungsgemäßen Kontaktfeder-Struktur versehen ist;
- Figur 6 :: eine Draufsicht auf die Darstellung gemäß Figur 5;
- Figur 7 :: eine Querschnittsdarstellung durch ein Gehäuse mit in einer Nut eingesetzter Leiterplatine, die über die erfindungsgemäßen Kontaktfederelemente mit dem Gehäuse kontaktiert ist;
- Figur 8 :: ein abgewandeltes Ausführungsbeispiel in Querschnittsdarstellung quer zur Längsrichtung des erfindungsgemäßen Kontaktstreifens;
- Figur 9 :: ein nochmals zu Figur 8 abgewandeltes Ausführungsbeispiel;
- Figur 10 :: ein abgewandeltes Ausführungsbeispiel in Seitendarstellung vergleichbar Figur 1;
- Figur 11 :: eine ausschnittsweise Seitendarstellung entsprechend Figur 10 zur Verdeutlichung des Funktionsmechanismus mit einer zu Figur 11 abgewandten Wirkungsweise;
- Figur 12a bis 12c :: drei Querschnittsdarstellungen bezüglich des Ausführungsbeispieles nach Figur 10 im eingebauten Zustand zur Verdeutlichung der Wirkungsweise in einem ersten möglichen Falle;
- Figur 13a und 13b :: zwei Abwandlungen zu der Darstellung gemäß Figur 11; und
- Figur 14 :: ein weiteres abgewandeltes Ausführungsbeispiel in Seitenansicht.

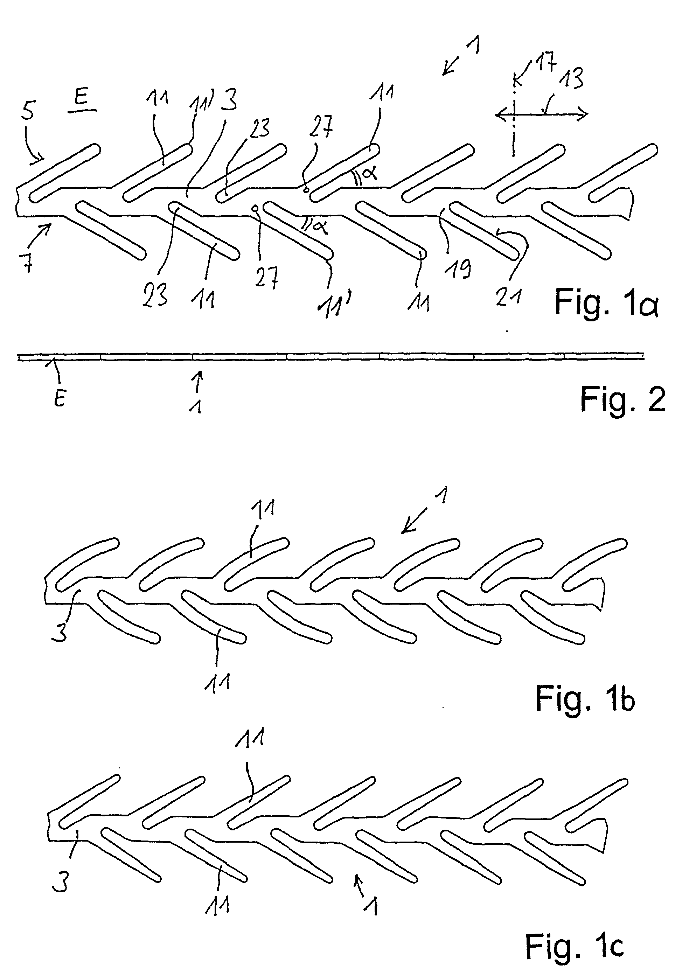

In den Figuren 1a und 2 ist ein erstes Ausführungsbeispiel für einen erfindungsgemäßen elektrischen Kontaktstreifen 1 gezeigt, welcher aus einem Materialstreifen mit guter elektrischer Leitfähigkeit besteht, welcher in einem entsprechenden Stanz- oder Schneideverfahren unter Einsatz an sich bekannter Stanz- oder Schneidmittel hergestellt ist. Das Material, das eine gute elektrische Leitfähigkeit aufweisen muss, also insbesondere Metall oder eine Metalllegierung, wird dabei so gewählt, dass die gewünschten elektrischen Eigenschaften realisierbar sind.

Das in Figur 1a in Seitenansicht und in Figur 2 in Draufsicht wiedergegebene Kontaktstreifenelement 1, welches also z. B. aus einem Metallstreifen oder einem Metallband hergestellt ist, umfasst einen nachfolgend auch als Mittellängsabschnitt 3 bezeichneten Materialabschnitt 3, an welchem an der oberen, also der einen Längsseite 5 ebenso wie an der unteren oder gegenüberliegenden Längsseite 7 federnde Kontaktfinger 11 ausgebildet sind.

Die Höhe des Mittellängsabschnittes 3 kann im Verhältnis zur Höhe der überstehenden federnden Kontaktfinger 11 in weiten Bereichen beliebig gewählt werden, so lange noch eine ausreichende Gesamtstabilität des Kontaktstreifens und Elastizität seiner Kontaktfinger 11 erzielt ist. Im gezeigten Ausführungsbeispiel beträgt die Höhe des Mittellängsabschnittes 3 ca. 10 bis 40 %, vorzugsweise 20 bis 25 % der Gesamthöhe des Kontaktstreifens 1, der z. B. eine Höhe von 4 bis 10 mm, z. B. um 6 bis 8 mm aufweisen kann.

Wie aus der Seitenansicht gemäß Figur 1a auch zu ersehen ist, liegen die Kontaktfinger 11 in der Kontaktstreifen-Ebene E und sind zur Längsrichtung 13 des Kontaktstreifens winkelig ausgerichtet. Der Neigungswinkel α zwischen der Ausrichtung des jeweiligen Kontaktfingers 11 zur Längsrichtung 13 des Kontaktstreifens kann in weiten Bereichen beliebig gewählt werden. In bestimmten Einsatzfällen kann sogar eine Querausrichtung von 90° quer zur Längsrichtung 13 des Kontaktstreifens noch zu realisierbaren Erfolgen führen. Bevorzugt wird jedoch die erwähnte geneigte Ausrichtung gewählt, wobei der Winkel α größer als 0° und kleiner als 90° sein soll, vorzugsweise zwischen 10° bis 80°, insbesondere 20° bis 70° liegt. Im gezeigten Ausführungsbeispiel ist ein Winkelbereich von 20° bis 60°, insbesondere um 30° bis 40° bevorzugt.

Im gezeigten Ausführungsbeispiel gemäß Figur 1a sind die oben- wie gegenüberliegenden unteren Kontaktfinger 11 in der gleichen Ausrichtung geneigt verlaufend ausgerichtet. Möglich wäre aber auch, dass die oberen und unteren Kontaktfinger gegenläufig ausgerichtet sind, also sowohl die oben- wie untenliegenden Kontaktfinger (bei gleichgroßem, aber gegensinnig ausgerichtetem Winkel α) insgesamt parallel zueinander liegen.

Um die wirkungsvolle Federlänge der Kontaktfinger zu vergrößern und damit den Fußpunkt 19 der einzelnen Kontaktfinger 11 mehr zur Mitte des Kontaktstreifens 1 zu verlegen, ist jeweils an der den spitzen Winkel α einschließenden Seite 21 des Kontaktfingers 11 noch eine Verlängerungsnut 23 in den Materialbereich des Mittellängsabschnittes des Kontaktstreifens eingebracht.

Wie aus der Draufsicht gemäß Figur 2 zu ersehen ist, ist der so gebildete elektrische Kontaktstreifen allein nur durch Stanzen oder ein anderes Schneidverfahren hergestellt, ohne dass ein zusätzlicher Prägevorgang notwendig ist (auch wenn zusätzlich die Finger noch einer gewissen Prägung - worauf später noch eingegangen wird - unterzogen werden können).

Die so gebildeten federnden Kontaktfinger 11 sind dann im Einsatzfalle um eine quer zur Kontaktstreifen-Ebene E und damit quer zur Zeichenebene E liegende Biegeachse 27 verformbar, die im Bereich des Fußpunktes 19 in Figur 1a angedeutet ist. In der Regel steht dabei die Biegeachse 27 senkrecht zur Kontaktstreifen-Ebene E.

Figur 1b zeigt, dass die Kontaktfinger auch gekrümmt ausgebildet sein können. Im Beispiel gemäß Figur 1b liegt dabei das Krümmungszentrum dem Mittelstreifen zugewandt. Figur 1c zeigt ferner, dass die Kontaktfingerkanten nicht zwingend parallel verlaufen müssen, sondern dass sich die Breite der Kontaktfinger von ihrer Basis zu ihrem freien Ende hin verändern, beispielsweise leicht verjüngen kann.

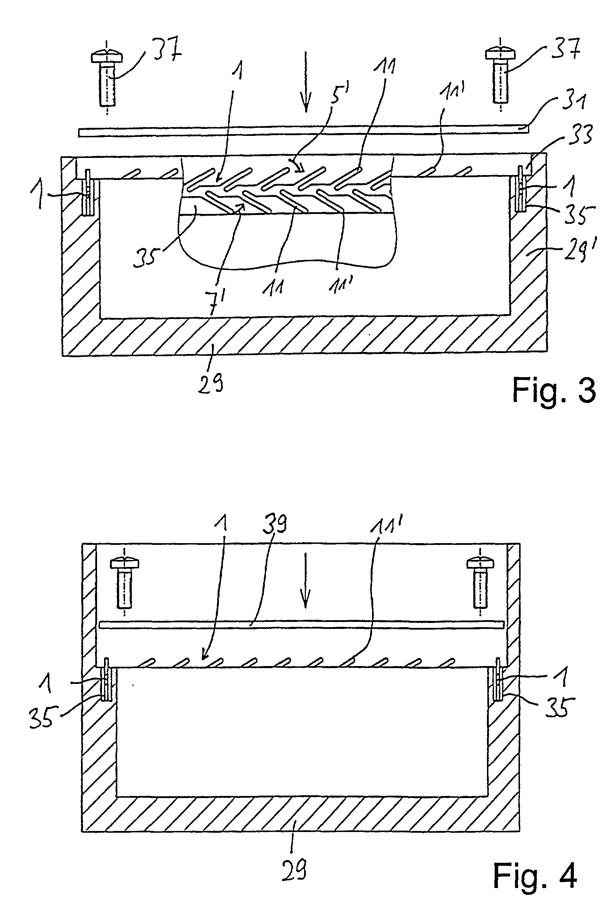

In Figur 3 ist nunmehr ein erstes Ausführungsbeispiel für die Verwendung des elektrischen Kontaktstreifens gezeigt.

Um ein boxenförmiges Gehäuse 29 mit einem zugehörigen Deckel 31 so zu verschließen, dass an der Verbindungsstelle insbesondere der Durchtritt hochfrequenter elektromagnetischer Wellen verhindert wird (weshalb Gehäuse und Deckel genau wie der Kontaktstreifen aus elektrisch leitendem Material, insbesondere elektrisch gut leitendem Material bestehen), ist an einem umlaufenden obenliegenden Stufenrand 33 in den Wänden 29' des Gehäuses 29 eine umlaufende Haltenut 35 eingebracht. In dieser Haltenut 35 muss nunmehr der Kontaktstreifen 1 in passender Länge nur eingelegt werden. Die Breite der Nut kann dabei durchaus größer sein als die Dicke des Kontaktfederelementes, da dies für dessen Funktion nicht bestimmend ist. Bei Gußteilen kann durch einfache Maßnahmen, z. B. indem man einen Bereich der Nut leicht gekrümmt ausführt, erreicht werden, dass der Kontaktstreifen aus der Nut nicht herausfallen kann und gleichzeitig das Einlegen des Kontaktstreifens nicht wesentlich erschwert wird. (In Figur 3 ist der hintenliegende, die Nut 35 teilweise verdeckende Wandabschnitt in der Zeichnung weggelassen worden.)

Um das gezeigte Gehäuse abzuschirmen, können mehrere gerade, gerade und gebogene oder mehrere gebogene Kontaktstreifen oder auch nur ein in die umlaufende Nut passender, mehrfach gebogener Kontaktstreifen verwendet werden.

Die Tiefe der Nut ist geringer als die Höhe des Kontaktstreifens 1, so dass am oberen Ende über die Nut die obenliegenden federnden Kontaktfinger 11 über die Haltenut 35 überstehen.

Nunmehr wird lediglich der Deckel aufgesetzt und beispielsweise über Schrauben 37 am Gehäuse befestigt, wobei durch die Preßwirkung nunmehr die obenliegenden Kontaktfinger 11 entsprechend der Pfeildarstellung 5' im Uhrzeigersinn und die untenliegenden Kontaktfederelemente 11 entsprechend der Pfeildarstellung 7' im Gegenuhrzeigersinn in Richtung auf den Mittellängsabschnitt 3 zu vorgespannt, also elastisch verformt werden. Da die federnden Kontaktfinger mit ihrem vorlaufenden freien Fingerende 11' sowohl im Nutbett der Haltenut 35 als auch mit ihren Fingerenden 11' der obenliegenden Kontaktfinger 11 an der Unterseite des Deckels 31 unter Federvorspannung anliegen, und dabei die Berührungsfläche sowohl zwischen Federfinger und Gehäuse als auch zwischen Federfinger und Deckel bedingt durch die geringe Dicke des Kontaktstreifens und das Stanzen klein ist, wird ein extrem guter elektrischer Kontakt durch eine Art Einkerbbewegung realisiert. Durch die kleine Berührungsfläche ergibt sich die erwähnte hohe Flächenpressung, wobei während der elastischen Vorspannbewegung der Kontaktfinger die Fingerenden 11' eine geringfügige Gleitbewegung ausführen und dabei gegebenenfalls sogar Korrosions- oder andere Fremdschichten durchstoßen können.

Das erfindungsgemäße Kontaktelement und dessen Kontaktfederelemente 11 zeichnen sich vor allem dadurch aus, dass die Kontaktrichtung nicht quer zur Kontaktfederelement-Ebene E ausgerichtet ist, sondern in der Ebene E der Kontaktfederelemente 11 liegt, nämlich in unmittelbarer Verlängerung der einzelnen Kontaktfinger 11. Die in der Fingerebene, d.h. am freien Ende in Richtung der Kontaktfinger 11 liegenden Fingerenden 11', also die entsprechende Schnitt- oder Stanzfläche im Bereich der Fingerenden 11' bilden somit die eigentlichen Kontaktierungsflächen.

Bei ausreichender Breite der oben erwähnten Nut 35 kann bei Bedarf sogar ein weiterer oder mehrere weitere Kontaktstreifen 1 in die Nut 35 eingelegt werden, so dass sich eine noch höhere Kontaktpunkt-Dichte ergibt.

Anhand von Figur 4 ist schematisch nur gezeigt, dass auf gleiche Weise eine elektrische Kontaktierung nicht nur zwischen dem Gehäuse 29 und einem Deckel 31, wie in Figur 3 gezeigt ist, sondern ebenso auch zwischen einem Gehäuse 29 und den Masse- oder Anschlusspunkten einer Leiterplatine 39 herstellbar ist. Die Leiterplatine 39 kann dabei z. B. mittels weniger Schrauben am Gehäuse fixiert werden. Der auf diese Art zwischen Gehäuse und Leiterplatte eingeschlossene Raum ist gegen hochfrequente elektromagnetische Wellen abgeschirmt.

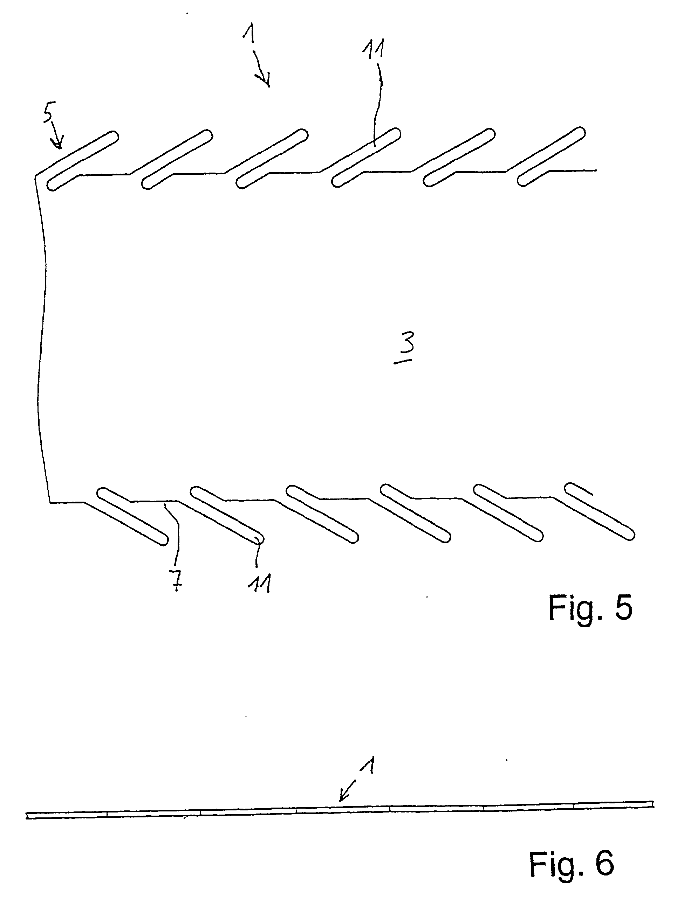

Bei dem Ausführungsbeispiel gemäß den Figuren 5 und 6 ist gezeigt, dass ein Kontaktstreifen 1 gleichzeitig auch die Funktion einer Wand oder Trennwand wahrnehmen kann. Dazu ist der Mittellängsabschnitt 3 vergleichsweise mit großer Höhe ausgestaltet, wobei der so gebildete Wandabschnitt an der Ober- oder/und Unterseite mit der Kontaktfinger-Struktur gemäß dem erläuterten Kontaktstreifen 1 versehen ist.

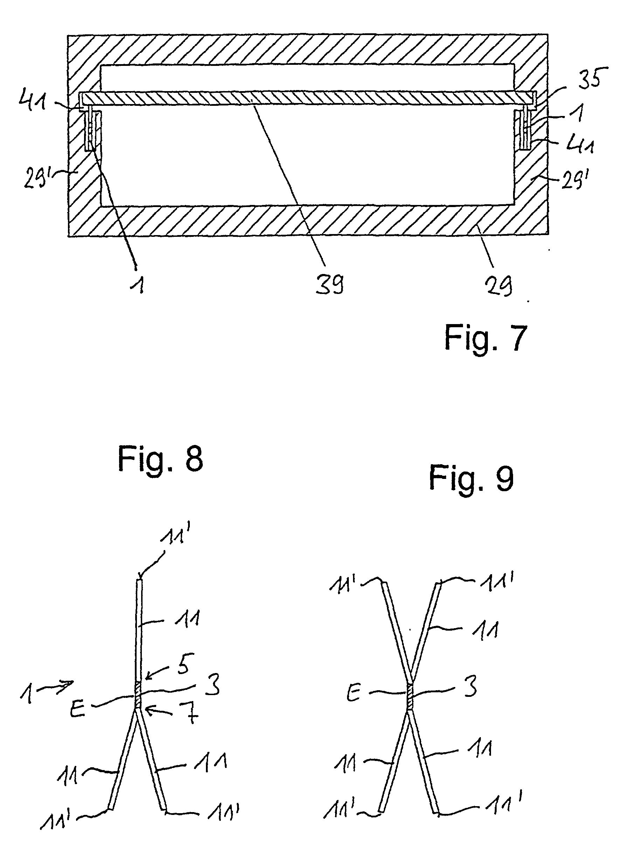

Bei dem Ausführungsbeispiel gemäß Figur 7 ist ein geschlossenes Gehäuse 29 im Querschnitt gezeigt, bei welchem an den gegenüberliegenden Wänden 29' jeweils eine Aufnahmenut 35 für eine Leiterplatine 39 ausgebildet ist, die in diese Aufnahmenuten 35 quer zur Zeichenebene eingeschoben werden kann. Die Leiterplatine 39 wird durch zwei in die gegenüberliegenden Schlitze 41 eingeschobene Kontaktstreifen 1 gehalten und elektrisch kontaktiert. Auch hier ist wieder die Gesamthöhe der Nut und der Schlitze 41 kleiner als die Gesamthöhe der Kontaktstreifen 1 plus der Dicke der Leiterplatine 39 im unkontaktierten Zustand. Dabei wird die Leiterplatine 39 so eingesteckt, dass sie bei der Darstellung gemäß Figur 2 von links nach rechts auf den Kontaktierungsstreifen 1 aufgeschoben wird, also in der Richtung eingeschoben wird, in der die Kontaktierungsfinger 11 geneigt sind.

Anhand der Figuren 8 und 9 ist nur gezeigt, dass der erfindungsgemäße Kontaktstreifen 1 auch noch einer zusätzlichen Verformung unterworfen werden kann, auch wenn dies nicht notwendig ist.

Dazu ist in Figur 8 in einem Querschnitt quer zur Längsrichtung 13 des Kontaktstreifens 1 wiedergegeben, dass beispielsweise an der unteren Längsseite 7 die dort vorgesehenen federnden Kontaktfinger 11 wechselweise leicht nach links bzw. nach rechts ausgestellt sind. Von daher ergibt sich in der gezeigten Querschnittsebene eine Y-Struktur. Aber auch bei dieser Funktionsweise wird der Kontaktstreifen 1 im Gebrauch so zwischen seiner Ober- und Unterseite, also zwischen den nach oben weisenden Fingerenden 11' und den nach unten weisenden jeweils abwechselnd leicht versetzt liegenden Fingerenden 11' zwischen zwei elektrisch zu kontaktierenden oder abzuschirmenden Bauteilen eingespannt, wobei sich die Kontaktfinger 11 gleichwohl um jeweils eine quer zur Kontaktstreifen-Ebene E ausgerichtet liegende Vorspannachse ganz oder zumindest mit einer Komponente im Einbaufalle elastisch verbiegen lassen.

Es ist ebenso möglich, nicht alle, sonder nur einige wenige Kontaktfinger aus der Kontaktstreifenerstreckungsebene herauszubiegen (wobei die Kontaktstreifenerstreckungsebene beispielsweise mit dem mittleren Kontaktstreifenabschnitt zusammenfällt), beispielsweise um den Kontaktstreifen nach dem Einlegen in das abzuschirmende Gehäuse unverlierbar zu fixieren.

Bei der Querschnittsdarstellung entsprechend Figur 9 sind ergänzend auch noch die obenliegenden Kontaktfinger 11 abwechselnd, also jedenfalls jeder zweite Finger zu dem dazwischenliegenden Kontaktfinger 11 unterschiedlich seitlich leicht ausgestellt, so dass sich im Querschnitt eine X-förmige Struktur ergibt.

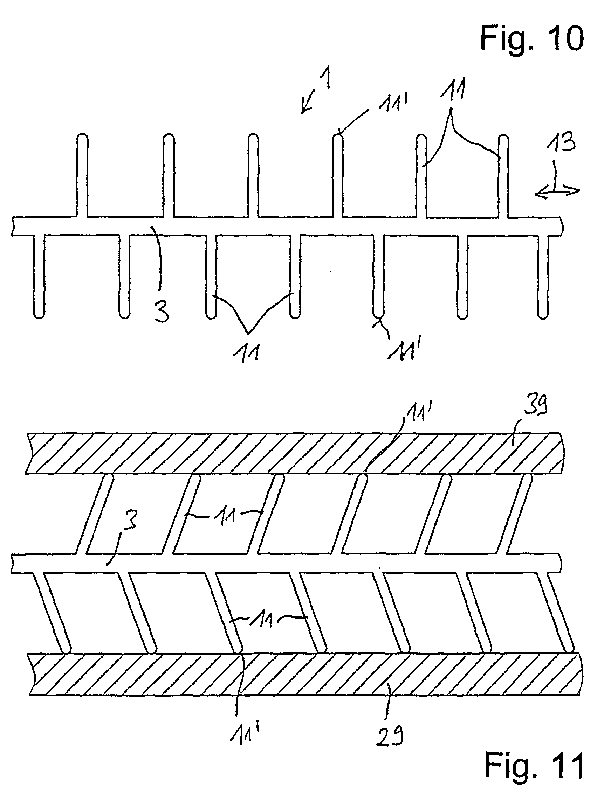

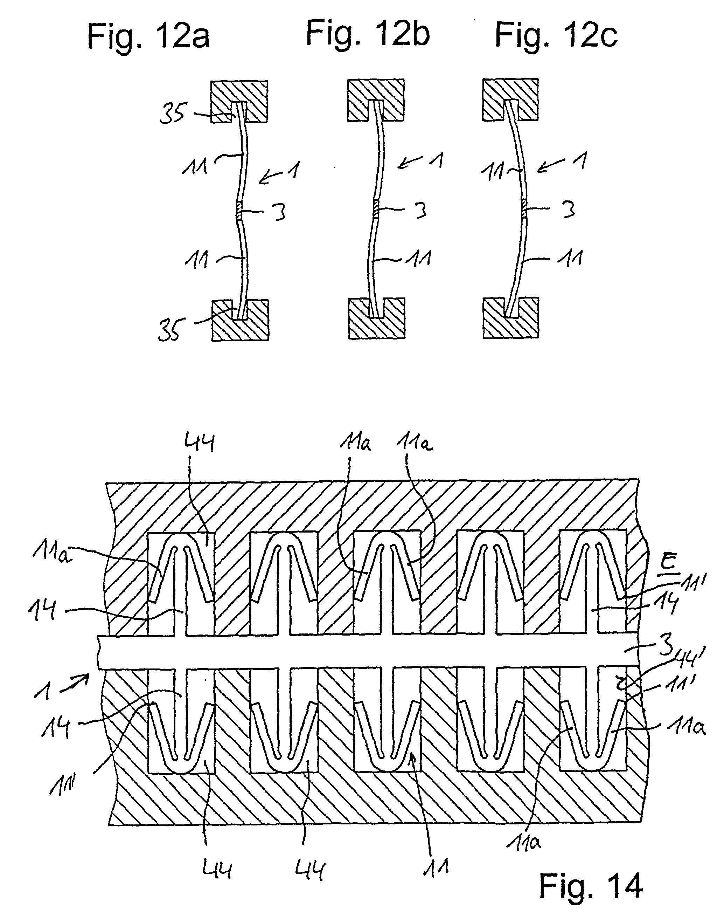

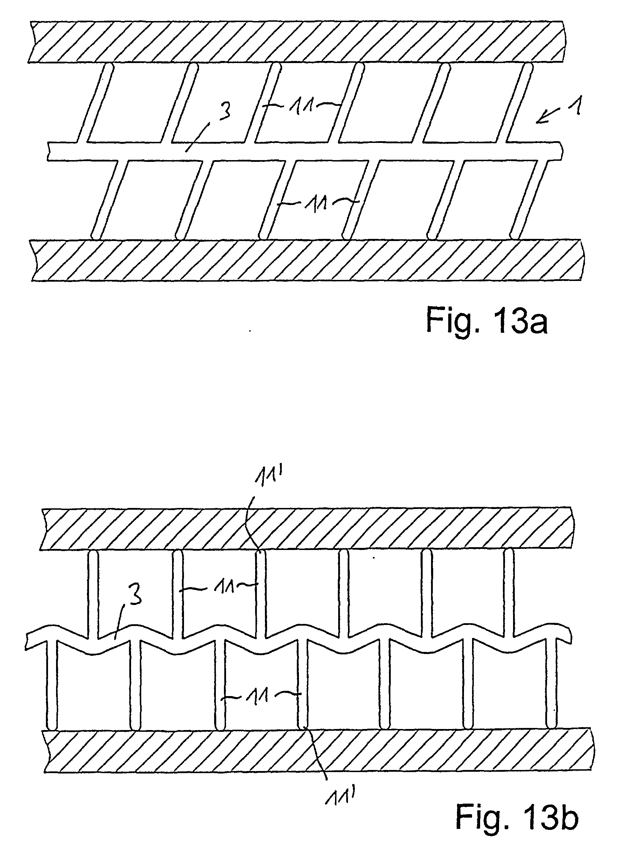

Anhand von Figur 10 ist eine Abwandlung zu Figur 1 insoweit gezeigt, dass hier die einzelnen Kontaktfinger 11 zur Längsrichtung des Kontaktstreifens rechtwinkelig in der Kontaktstreifen-Ebene E liegend ausgerichtet sind. Beim Zusammenbau z. B. mit zwei zu kontaktierenden Bauteilen 29 und 39 erfolgt eine Druckbeanspruchung auf die oberen wie unteren Kontaktfinger 11 und damit die Fingerenden 11' entgegengesetzt der Ausrichtung der Kontaktfinger 11, mit der Folge, dass je nach der Aufsetzbewegung diese Kontaktfinger eine leichte Verspannbewegung in Richtung Neigung der Kontaktfinger 11 in der Kontaktfingerebene E liegend vollführen (in Figur 11 in gleicher Richtung und in Figur 13a in entgegengesetzter Richtung), oder aber insoweit "gestaucht" werden (Figuren 12a, 12b bzw. 12c), dass unter geringfügiger Verringerung der effektiven wirksamen Höhe der Kontaktfingerenden 11' diese leicht seitlich ausgebaucht werden. Insbesondere dann aber, wenn ein mit dem in Figur 10 wiedergegebenen Kontaktelement zusammenwirkendes Bauteil mit Bewegungskomponente in Längsrichtung 13 des Kontaktelementes relativ zu diesem aufgesetzt wird, werden die Finger von ihrer Vertikalerstreckung entsprechend der Bewegungskomponente in die in Figur 11 oder 13a dargestellte und zur Längsrichtung geneigt verlaufende Ausrichtung unter Vorspannung elastisch gebogen.

In Figur 13b ist gezeigt, dass u.U. auch der Mittelsteg 3 beim Zusammenfügen der zu kontaktierenden Bauteile leicht elastisch verformt wird, was in Figur 13b überdimensional stark gezeigt ist. Die elastische Verformung ermöglicht dabei, dass die wirksame Abstandslänge zwischen dem gegenüberliegenden Kontaktflächen 11' zweier unterschiedlich ausgerichteter Kontaktfinger 11 beim Zusammenfügen der zu kontaktierenden Bauteile zumindest leicht verringert wird. Dabei kann auch vorgesehen sein, dass der sich dadurch leicht zickzack- oder wellenförmig verformte Mittelteil 3 bereits von Hause aus leicht zickzack- oder wellenförmig vorgeformt (also z. B. ausgestanzt) ist.

Anhand von Figur 14 ist schließlich noch ein weiteres abgewandeltes Ausführungsbeispiel gezeigt. Der Seitendarstellung entsprechend Figur 14 ist zu entnehmen, dass die Kontaktfinger mehrgliedrig gestaltet sind und Kontaktfinger-Abschnitte 14 umfassen, die an dem Mittelsteg 3 seitlich gegenüberliegend wegragen, an deren außenliegendem Ende ein oder zwei bevorzugt in der Kontaktstreifenebene E liegende Kontaktfinger-Endabschnitt 11a ausgebildet sind. Auch dieser Kontaktstreifen kann allein nur durch Stanzen hergestellt sein. Die Kontaktfinger 11 verlaufen von dem verjüngten Übergang zum Kontaktfinger-Abschnitt 14 ausgehend wieder in Richtung Mittelsteg 3 zurück, und zwar gegenüber dem Seitenarm in geneigter Ausrichtung (winkelig). Dieses Ausführungsbeispiel kann eingesetzt werden, wenn die zu kontaktierenden Bauteile, abgesehen von einer umlaufenden Nut oder einem Freiraum zum Einführen des Mittellängsabschnittes 3, zusätzlich zumindest in ausreichender Tiefe vorgesehene nutförmige Taschen 44 aufweisen, die in der Tiefe und vor allem Breite an das Abstandsmaß der Kontaktfinger 11 angepasst sind. Die Fingerenden 11' kerben sich dabei mit ihrer Stanzoder Schnittfläche an den Seitenwänden 44' der zu kontaktierenden Bauteile in den Kontakttaschen 44 ein, da die Breite der Taschen 44 geringfügig kleiner ist als die Breite der gegenüberliegenden Kontaktspitzen 11' zweier an einem Kontaktfinger-Abschnitt 14 sitzenden Kontaktfinger-Endabschnitt 11a, wenn sich diese im unbelasteten nicht eingesetzten Zustand befinden. Auch dadurch wird die erwähnte elastische Verformung und Kontaktierung bewerkstelligt.

## Patentansprüche

1. Kontaktstreifen zum elektrischen Kontaktieren und zur Erzielung einer gegen hochfrequente elektromagnetische Wellen dichten Verbindung zwischen zwei Bauteilen, insbesondere zwischen einem Gehäuse und einem Gehäusedeckel, mit federnd verformbaren Kontaktelementen (1) in Form von Kontaktfingern (11), die zumindest auf einer Längsseite (5, 7) eines die Kontaktfinger (11) verbindenden und haltenden Materialabschnittes ausgebildet sind, **gekennzeichnet durch** die folgenden Merkmale:
- die Kontaktfinger (11) liegen in der Ebene des sie tragenden Materialabschnittes (3), und
- die Kontaktfinger (11) sind in der Ebene (E) des Materialabschnittes (3) beim Einsatz und Zusammenbau verformbar.

2. Kontaktstreifen zum elektrischen Kontaktieren und zur Erzielung einer gegen hochfrequente elektromagnetische Wellen dichten Verbindung zwischen zwei Bauteilen, insbesondere zwischen einem Gehäuse und einem Gehäusedeckel, mit federnd verformbaren Kontaktelementen (1) in Form von Kontaktfingern (11), die zumindest auf einer Längsseite (5, 7) eines die Kontaktfinger (11) verbindenden und haltenden Materialabschnittes ausgebildet sind, wobei zumindest einige Kontaktfinger (11) gegenüber der Ebene (E) des Materialabschnittes (3) des Kontaktstreifens mit Querkomponente aufgestellt sind, **gekennzeichnet durch** die folgenden weiteren Merkmale
- zumindest einige Kontaktfinger (11) sind gegenüber der Ebene (E) des Materialabschnittes (3) des Kontaktstreifens derart mit Seitenkomponente aufgestellt, dass in quer zur Längsrichtung des Kontaktelementes betrachtet die Kontaktfinger (11) zumindest auf einer Längsseite (5, 7) des Materialabschnittes (3) V-förmig zu liegen kommen, und
- die Kontaktfinger (11) sind im wesentlichen parallel zur Ebene (E) des Materialabschnittes (3) oder in der Ebene der Kontaktfinger (11) beim Einsatz und Zusammenbau verformbar.

3. Kontaktstreifen nach Anspruch 1 oder 2, **dadurch gekennzeichnet, dass** die Kontaktfinger (11) zur Längsrichtung (13) des Kontaktstreifens (1) geneigt ausgerichtet sind und um eine Biegeachse (27) quer zur Längsrichtung (13) des Kontaktstreifens (1) elastisch verformbar sind.

4. Kontaktstreifen nach Anspruch 3, **dadurch gekennzeichnet, dass** die Kontaktfinger (11) in gleicher Neigungsrichtung geneigt verlaufend ausgebildet sind.

5. Kontaktstreifen nach Anspruch 3, **dadurch gekennzeichnet, dass** die Kontaktfinger (11) an der oberen und unteren Seite des Kontaktstreifens (1) in entgegengesetzter Neigungsrichtung geneigt verlaufend ausgebildet sind.

6. Kontaktstreifen nach einem der Ansprüche 3 bis 5, **dadurch gekennzeichnet, dass** der Neigungswinkel (α) kleiner oder gleich 90°, insbesondere kleiner als 70°, 60° und insbesondere 50° ist.

7. Kontaktstreifen nach einem der Ansprüche 3 bis 6, **dadurch gekennzeichnet, dass** der Neigungswinkel (α) größer als 10°, insbesondere größer als 20°, vorzugsweise um 30° ist.

8. Kontaktstreifen nach einem der Ansprüche 1 bis 7, **dadurch gekennzeichnet, dass** die Kontaktfinger (11) gerade verlaufen.

9. Kontaktstreifen nach einem der Ansprüche 1 bis 7, **dadurch gekennzeichnet, dass** die Kontaktfinger (11) gekrümmt verlaufen, wobei deren Krümmungszentrum vorzugsweise dem Materialabschnitt (3) zugewandt liegt.

10. Kontaktstreifen nach einem der Ansprüche 1 bis 9, **dadurch gekennzeichnet, dass** die gegenüberliegenden Kontaktfingerkanten parallel zueinander verlaufen.

11. Kontaktstreifen nach einem der Ansprüche 1 bis 10, **dadurch gekennzeichnet, dass** die Kontaktfinger (11) über ihre Gesamtlänge mit unterschiedlicher Breite dimensioniert sind, vorzugsweise zu ihrem Kontaktfingerende hin sich verjüngen.

12. Kontaktstreifen nach einem der Ansprüche 1 bis 11, **dadurch gekennzeichnet, dass** die Breite der Kontaktfinger (11') in der Kontaktelement-Ebene (E) der halben bis dreifachen Materialdicke des Kontaktstreifens (1) entspricht.

13. Kontaktstreifen nach einem der Ansprüche 1 bis 12, **dadurch gekennzeichnet, dass** der Abstand zwischen den Kontaktfingern (11) an einer Seite des Kontaktstreifens etwa dem Drei- bis Zehnfachen, insbesondere dem Fünffachen der Breite der Kontaktfinger (11) entspricht.

14. Kontaktstreifen nach einem der Ansprüche 1 bis 13, **dadurch gekennzeichnet, dass** an der Seite (21) des jeweiligen Kontaktfingers (11), der den spitzen Winkel (α) mit dem Materialabschnitt (3) des Kontaktstreifens (1) einschließt, eine in den Materialbereich des Materialabschnittes (3) verlaufende Verlängerungsnut (23) eingebracht ist.

15. Kontaktstreifen nach einem der Ansprüche 1 bis 14, **dadurch gekennzeichnet, dass** die Kontaktfinger (11) an beiden gegenüberliegenden Längsseiten (5, 7) ausgebildet sind.

16. Kontaktstreifen nach einem der Ansprüche 1 bis 15, **dadurch gekennzeichnet, dass** die auf der einen Längsseite (5) ausgebildeten Kontaktfinger (11) zu den auf der gegenüberliegenden Längsseite (7) ausgebildeten Kontaktfinger (11) um die halbe Abstandsfolge versetzt zueinander liegen.

17. Kontaktstreifen nach einem der Ansprüche 1 bis 16, **dadurch gekennzeichnet, dass** sich die Fingerenden (11') beim Einbau eines Kontaktstreifens (1) in die damit zusammenwirkenden Bauteile (29, 31, 39) einkerben.

18. Kontaktstreifen nach einem der Ansprüche 1 bis 17, **dadurch gekennzeichnet, dass** die Kontaktfinger (11) mehrgliedrig ausgebildet sind und einen Kontaktfinger-Abschnitt (14) umfassen, der an einer zugehörigen Längsseite (5, 7) des Materialabschnittes (3) wegragt, wobei vorzugsweise am Ende dieses Kontaktfinger-Abschnittes (14) ein Kontaktfinger-Endabschnitt (11a) sitzt, der in Richtung Materialabschnitt (3) verläuft.

19. Kontaktstreifen nach Anspruch 18, **dadurch gekennzeichnet, dass** zumindest näherungsweise in der Kontaktelement-Ebene (E) liegend beidseitig zu dem Kontaktfinger-Abschnitt (14) zwei Kontaktfinger-Endabschnitte (11a) sitzen.

20. Kontaktstreifen nach Anspruch 18 oder 19, **dadurch gekennzeichnet, dass** die beiden an dem Kontaktfinger-Abschnitt (14) sitzenden Kontaktfinger-Endabschnitte (11a) von ihrem Ausgangspunkt am Kontaktfinger-Abschnitt (14) in Richtung Materialabschnitt (3) zurückverlaufend ausgerichtet und in Richtung des Kontaktfinger-Abschnitts (14) elastisch verformbar sind.

21. Kontaktstreifen nach einem der Ansprüche 1 bis 20, **dadurch gekennzeichnet, dass** der Materialabschnitt (3) zickzack- oder wellenförmig gestaltet und/oder verformbar ist.

22. Abschirmanordnung mit einem Kontaktstreifen nach einem der Ansprüche 1 bis 21.

## Claims

1. Strip for making electrical contact and for EMI shielding as a connection between two components, in particular between a housing and a housing cover, with resiliently deformable contact elements (1) in the form of contact fingers (11), which are formed at least on one longitudinal side (5, 7) of a material portion connecting and holding the contact fingers (11), **characterized by** the following features:
- the contact fingers (11) lie in the plane of the material portion (3) carrying them, and
- the contact fingers (11) are deformable in the plane (E) of the material portion (3) during insertion and assembly.

2. Strip for making electrical contact and for EMI shielding as a connection between two components, in particular between a housing and a housing cover, with resiliently deformable contact elements (1) in the form of contact fingers (11), which are formed at least on one longitudinal side (5, 7) of a material portion connecting and holding the contact fingers (11), at least some contact fingers (11) being raised up with a transverse component with respect to the plane (E) of the material portion (3) of the contact strip, **characterized by** the following further features
- at least some contact fingers (11) are raised up with respect to the plane (E) of the material portion (3) of the contact strip with a side component in such a way that, viewed transversely in relation to the longitudinal direction of the contact element, the contact fingers (11) come to lie in a V-shaped manner at least on one longitudinal side (5, 7) of the material portion (3), and
- the contact fingers (11) are deformable substantially parallel to the plane (E) of the material portion (3) or in the plane of the contact fingers (11) during insertion and assembly.

3. Contact strip according to Claim 1 or 2, **characterized in that** the contact fingers (11) are aligned in an inclined manner with respect to the longitudinal direction (13) of the contact strip (1) and are elastically deformable about a bending axis (27) transversely in relation to the longitudinal direction (13) of the contact strip (1).

4. Contact strip according to Claim 3, **characterized in that** the contact fingers (11) are formed such that they run in an inclined manner in the same direction of inclination.

5. Contact strip according to Claim 3, **characterized in that** the contact fingers (11) are formed such that they run in an inclined manner in opposite directions of inclination on the upper and lower side of the contact strip (1).

6. Contact strip according to one of Claims 3 to 5, **characterized in that** the angle of inclination (α) is less than or equal to 90°, in particular less than 70°, 60° and in particular 50°.

7. Contact strip according to one of Claims 3 to 6, **characterized in that** the angle of inclination (α) is greater than 10°, in particular greater than 20°, preferably 30°.

8. Contact strip according to one of Claims 1 to 7, **characterized in that** the contact fingers (11) run in a straight manner.

9. Contact strip according to one of Claims 1 to 7, **characterized in that** the contact fingers (11) run in a curved manner, the centre of curvature preferably lying such that it is towards the material portion (3).

10. Contact strip according to one of Claims 1 to 9, **characterized in that** the opposite contact finger edges run parallel to one another.

11. Contact strip according to one of Claims 1 to 10, **characterized in that** the contact fingers (11) are dimensioned with varying width over their overall length, preferably taper towards their contact finger end.

12. Contact strip according to one of Claims 1 to 11, **characterized in that** the width of the contact fingers (11') in the contact element plane (E) corresponds to half to three times the material thickness of the contact strip (1).

13. Contact strip according to one of Claims 1 to 12, **characterized in that** the spacing between the contact fingers (11) on one side of the contact strip corresponds to approximately three to ten times, in particular five times, the width of the contact fingers (11).

14. Contact strip according to one of Claims 1 to 13, **characterized in that** an extension groove (23), running into the material region of the material portion (3), has been made on the side (21) of the respective contact finger (11) which forms the acute angle (α) with the material portion (3) of the contact strip (1).

15. Contact strip according to one of Claims 1 to 14, **characterized in that** the contact fingers (11) are formed on both opposite longitudinal sides (5, 7).

16. Contact strip according to one of Claims 1 to 15, **characterized in that** the contact fingers (11) formed on one longitudinal side (5) lie offset by half the spacing sequence with respect to the contact fingers (11) formed on the opposite longitudinal side (7).

17. Contact strip according to one of Claims 1 to 16, **characterized in that** the ends of the fingers (11') cut into the components (29, 31, 39) interacting with them during the installation of a contact strip (1).

18. Contact strip according to one of Claims 1 to 17, **characterized in that** the contact fingers (11) are formed in a multi-element manner and comprise a contact finger portion (14) which extends away on an associated longitudinal side (5, 7) of the material portion (3), with a contact finger end portion (11a) which runs in the direction of the material portion (3) preferably being located at the end of this contact finger portion (14).

19. Contact strip according to Claim 18, **characterized in that** two contact finger end portions (11a) are located at least approximately in the contact element plane (E), lying on either side of the contact finger portion (14).

20. Contact strip according to Claim 18 or 19, **characterized in that** the two contact finger end portions (11a) located on the contact finger portion (14) are aligned such that they run back from their starting point on the contact finger portion (14) in the direction of the material portion (3) and are elastically deformable in the direction of the contact finger portion (14).

21. Contact strip according to one of Claims 1 to 20, **characterized in that** the material portion (3) is shaped and/or deformable in a zigzag or wave-formed manner.

22. Shielding device with a contact strip according to one of Claims 1 to 21.

## Revendications

1. Bande de contact pour la mise en contact électrique et pour obtenir une liaison étanche vis-à-vis des ondes électromagnétiques de haute fréquence entre deux composants, en particulier entre un boîtier et un couvercle de boîtier, comportant des éléments de contact (1) élastiquement déformables sous forme de doigts de contact (11) qui sont réalisés au moins sur un côté longitudinal (5, 7) d'un tronçon de matériau reliant et retenant les doigts de contact (11), **caractérisée par** les éléments suivants :
- les doigts de contact (11) se trouvent dans le plan du tronçon de matériau (3) qui les porte, et
- les doigts de contact (11) sont déformables dans le plan (E) du tronçon de matériau lors de la mise en place et de l'assemblage.

2. Bande de contact pour la mise en contact électrique et pour obtenir une liaison étanche vis-à-vis des ondes électromagnétiques de haute fréquence entre deux composants, en particulier entre un boîtier et un couvercle de boîtier, comportant des éléments de contact (1) élastiquement déformables sous forme de doigts de contact (11) qui sont réalisés au moins sur un côté longitudinal (5, 7) d'un tronçon de matériau reliant et retenant les doigts de contact (11), quelques-uns au moins des doigts de contact (11) étant dressés avec une composante transversale par rapport au plan (E) du tronçon de matériau (3) de la bande de contact, **caractérisé par** les éléments suivants :
- quelques-uns au moins des doigts de contact (11) sont dressés avec une composante latérale par rapport au plan (E) du tronçon de matériau (3) de la bande de contact, de telle sorte que les doigts de contact (11) viennent se poser en forme de V au moins sur un côté longitudinal (5, 7) du tronçon de matériau (3), vus transversalement à la direction longitudinale de l'élément de contact, et
- les doigts de contact (11) sont déformables sensiblement parallèlement au plan (E) du tronçon de matériau (3) ou dans le plan des doigts de contact (11) lors de la mise en place et de l'assemblage.

3. Bande de contact selon l'une ou l'autre des revendications 1 et 2, **caractérisée en ce que** les doigts de contact (11) sont orientés de façon inclinée par rapport à la direction longitudinale (13) de la bande de contact (1) et élastiquement déformables autour d'un axe de flexion (27) transversalement à la direction longitudinale (13) de la bande de contact (1).

4. Bande de contact selon la revendication 3, **caractérisée en ce que** les doigts de contact (11) sont réalisés de manière à s'étendre sous une inclinaison dans la même direction d'inclinaison.

5. Bande de contact selon la revendication 3, **caractérisée en ce que** les doigts de contact (11) sont réalisés de manière à s'étendre sous une inclinaison dans des directions d'inclinaison opposées sur le côté supérieur et sur le côté inférieur de la bande de contact.

6. Bande de contact selon l'une des revendications 3 à 5, **caractérisée en ce que** l'angle d'inclinaison (α) est inférieur ou égal à 90°, en particulier inférieur à 70°, à 60° et en particulier égal à 50°.

7. Bande de contact selon l'une des revendications 3 à 6, **caractérisée en ce que** l'angle d'inclinaison (α) est supérieur à 10°, en particulier supérieur à 20°, de préférence égal à environ 30°.

8. Bande de contact selon l'une des revendications 1 à 7, **caractérisée en ce que** les doigts de contact (11) s'étendent en ligne droite.

9. Bande de contact selon l'une des revendications 1 à 7, **caractérisée en ce que** les doigts de contact (11) s'étendent de façon incurvée, leur centre de courbure étant tourné de préférence vers le tronçon de matériau (3).

10. Bande de contact selon l'une des revendications 1 à 9, **caractérisée en ce que** les arêtes de doigts de contact opposées s'étendent parallèlement les unes aux autres.

11. Bande de contact selon l'une des revendications 1 à 10, **caractérisée en ce que** les doigts de contact (11) sont dimensionnés avec des largeurs différentes sur toute leur longueur, de préférence ils vont en se rétrécissant vers leur extrémité.

12. Bande de contact selon l'une des revendications 1 à 11, **caractérisée en ce que** la largeur des doigts de contact (11') dans le plan (E) des éléments de contact correspond à une valeur allant de la moitié jusqu'au triple de l'épaisseur de matériau de 1a bande de contact (1).

13. Bande de contact selon l'une des revendications 1 à 12, **caractérisée en ce que** la distance entre les doigts de contact (11) sur un côté de la bande de contact est environ trois à dix fois, en particulier cinq fois supérieure à la largeur des doigts de contact (11).

14. Bande de contact selon l'une des revendications 1 à 13, **caractérisée en ce qu'**il est prévu, sur le côté (21) du doigt de contact respectif (11) qui enforme l'angle aigu (α) avec le tronçon de matériau (3) de la bande de contact (1), une gorge de prolongement (23) s'étendant dans la zone du tronçon de matériau (3).

15. Bande de contact selon l'une des revendications 1 à 14, **caractérisée en ce que** les doigts de contact (11) sont réalisés sur les deux côtés longitudinaux opposés (5, 7).

16. Bande de contact selon l'une des revendications 1 à 15, **caractérisée en ce que** les doigts de contact (11) réalisés sur l'un des côtés longitudinaux (5) sont décalés de la moitié de l'écartement par rapport aux doigts de contact (11) réalisés sur le côté longitudinal opposé (7).

17. Bande de contact selon l'une des revendications 1 à 16, **caractérisée en ce que** les extrémités (11') des doigts s'entaillent dans les composants (29, 31, 39) coopérant avec la bande de contact (1) lors du montage de cette dernière.

18. Bande de contact selon l'une des revendications 1 à 17, **caractérisée en ce que** les doigts de contact (11) sont réalisés en plusieurs pièces et comprennent un tronçon de doigt de contact (14) qui fait saillie d'un côté longitudinal associé (5, 7) du tronçon de matériau (3), un tronçon de doigt de contact (11a) reposant de préférence à l'extrémité de ce tronçon de doigt de contact (14) et s'étendant en direction du tronçon de matériau (3).

19. Bande de contact selon la revendication 18, **caractérisée en ce que** deux tronçons d'extrémité de doigt de contact (11a) reposent au moins approximativement dans le plan (E) de l'élément de contact ses deux côtés du tronçon de doigt de contact (14).

20. Bande de contact selon l'une ou l'autre des revendications 18 et 19, **caractérisée en ce que** les deux tronçons d'extrémité (11a) du doigt de contact reposant sur le tronçon de doigt de contact (14) sont orientés de manière à s'étendre à partir de leur point initial sur le tronçon de doigt de contact (14) en retour en direction du tronçon de matériau (3) et sont élastiquement déformables en direction du tronçon de doigt de contact (14).

21. Bande de contact selon l'une des revendications 1 à 20, **caractérisée en ce que** le tronçon de matériau (3) est réalisé et/ou déformable en forme de zigzag ou ondulée.

22. Agencement de blindage comportant une bande de contact selon l'une des revendications 1 à 21.
